# EUROPÄISCHE PATENTSCHRIFT

(11) **EP 1 505 536 B1**
(45) Veröffentlichungstag und Bekanntmachung des Hinweises auf die Patenterteilung: **16.07.2008**
(21) Anmeldenummer: 04017721.4
(22) Anmeldetag: 27.07.2004
(51) Int. Cl.: G06K 19/073

(54) **Speichern von Daten in einem nicht-flüchtigen Speicher eines tragbaren Datenträgers**
Storing data in a nonvolatile memory of a portable data carrier
Stockage d'élements de données dans une mémoire nonvolatile d'un support de données portable

(30) Priorität: 04.08.2003 DE 10335612
(43) Veröffentlichungstag der Anmeldung: 09.02.2005
(73) Patentinhaber: Giesecke & Devrient GmbH, 81677 München (DE)
(72) Erfinder: Stocker, Thomas, 81825 München (DE); Baldischweiler, Michael, 81825 München (DE)
(74) Vertreter: Dendorfer, Claus

(56) Entgegenhaltungen:
- EP-A- 0 357 361
- US-A- 4 870 574
- US-A- 5 625 791

## Beschreibung

Die Erfindung betrifft allgemein tragbare Datenträger und spezieller das Speichern von Daten in einem nicht-flüchtigen Speicher eines tragbaren Datenträgers. Ein tragbarer Datenträger im Sinne des vorliegenden Dokuments kann insbesondere eine Chipkarte *(smart card)* in unterschiedlichen Bauformen oder ein Chipmodul oder eine sonstige ressourcenbeschränkte Vorrichtung sein.

Tragbare Datenträger enthalten in der Regel einen beschreibbaren, nicht-flüchtigen Speicher, der beispielsweise als EEPROM *(electrically erasable programmable read-only memory -* elektrisch löschbarer, programmierbarer Nur-Lese-Speicher) ausgestaltet sein kann. Jede Speicherzelle eines EEPROM-Speichers weist einen Kondensator auf, dessen Ladungszustand den in der EEPROM-Zelle gespeicherten Datenwert repräsentiert. Zum Beschreiben bzw. Löschen der EEPROM-Zelle wird der Kondensator geladen bzw. entladen. Wegen der Selbstentladung des Kondensators weisen EEPROM-Zellen nur eine beschränkte Datenhaltezeit auf. Für Daten, die in einem regulären Schreibmodus in den Speicher geschrieben werden, stellt dies kein echtes Problem dar, da die Datenhaltezeit in diesem Fall mehr als zehn Jahre und damit mehr als die Lebensdauer des Datenträgers beträgt.

Ein bedeutender Nachteil von EEPROM-Speicher ist, daß zum Einschreiben von Daten in den Speicher viel Zeit benötigt wird. Die Schreibzeit pro Speicherzelle bei einem regulären Schreibvorgang kann beispielsweise 3 -10 ms betragen und damit ungefähr 100.000-mal größer als die typische Schreibzeit für einen flüchtigen Schreib-Lese-Speicher (RAM) sein. Diese lange Schreibzeit bedeutet eine erhebliche Einschränkung der effektiven Leistung des Datenträgers, da in der Regel der Programmablauf erst nach Abschluß des Schreibvorgangs fortgesetzt werden kann. Die für Schreibvorgänge in den EEPROM-Speicher benötigte Zeit stellt in vielen Anwendungen einen "Flaschenhals" für die Gesamtleistung des Datenträgers dar, da sie einen erheblichen Teil der insgesamt für die Programmausführung benötigten Zeit bildet. Eine Reduktion der Schreibzeit würde daher die Leistung des Datenträgers sehr stark erhöhen.

Es ist kürzlich ein EEPROM-Speicher vorgeschlagen worden, der einen beschleunigten Schreibmodus unterstützt. Im beschleunigten Schreibmodus reduziert sich die Schreibzeit erheblich, beispielsweise auf 1/3 der regulären Schreibzeit. Die Datenhaltezeit verringert sich jedoch entsprechend. Die Verwendung des beschleunigten Schreibmodus ist daher problematisch, weil die Datenhaltezeit in diesem Fall möglicherweise geringer als die Lebensdauer des Datenträgers ist. Es besteht ein Bedürfnis, diesen beschleunigten Schreibmodus ohne Beeinträchtigung der Datensicherheit nutzbar zu machen.

Aus dem US-Patent 5,625,791 ist eine Chipkarte mit einem EEPROM-Speicher bekannt, der in Zonen mit dauerhaften Informationen und Zonen mit variablen Informationen aufgeteilt ist. Die Speicherzonen mit dauerhaften Informationen werden periodisch aufgefrischt, während für die Zonen mit variablen Informationen keine Auffrischung vorgesehen ist. Die Verwendung eines beschleunigten Schreibmodus ist nicht offenbart. Für den regulären Schreibmodus stellt sich jedoch das dem US-Patent 5,625,791 zugrundeliegende Problem bei heutigen EEPROM-Speichern nicht mehr, da diese, wie oben erwähnt, eine ausreichend lange Datenhaltezeit aufweisen.

US 4 870 574 beschreibt einen Herstellungsprozess für tragbare Datenträger, in welchem der Datenträger beim Hersteller in einem schnellen Modus, der nicht die höchstmögliche Datenbeständigkeit garantiert, mit Daten beschrieben wird. Zum Zeitpunkt der Verwendung der Speicherkarte erfolgen sowohl eine Auffrischung der im schnellen Modus geschriebenen Daten als auch weitere Schreibvorgänge beim Benutzer jeweils in einem normalen Modus, der die volle Datenerhaltungszeit garantiert.

Die Erfindung hat die Aufgabe, eine Technik zum Speichern von Daten in einem nicht flüchtigen Speicher bereitzustellen, die einerseits geringe Schreibzeiten ermöglicht und andererseits eine zuverlässige Datenhaltung über die gesamte Lebensdauer des Datenträgers hinweg sicherstellt. In bevorzugten Ausgestaltungen soll diese Aufgabe insbesondere für Daten gelöst werden, die sich möglicherweise - aber nicht sicher - bald wieder ändern werden.

Erfindungsgemäß wird diese Aufgabe ganz oder zum Teil gelöst durch ein Verfahren zum Speichern von Daten gemäß Anspruch 1, ein Computerprogrammprodukt gemäß Anspruch 14 und einen tragbaren Datenträger gemäß Anspruch 15. Die abhängigen Ansprüche betreffen bevorzugte Ausführungsformen der Erfindung.

Die Erfindung beruht auf der Grundidee, die Daten unter Verwendung des beschleunigten Schreibmodus in den nicht-flüchtigen Speicher zu schreiben. Dies bewirkt eine erhebliche Zeiteinsparung, die um so größer ist, je mehr Schreibvorgänge in den nicht-flüchtigen Speicher durchgeführt werden. Ferner wird zu mindestens einem späteren Zeitpunkt - in manchen Ausgestaltungen nur einmal, in anderen öfter - ein Auffrischungsvorgang für die Daten durchgeführt. Der Auffrischungsvorgang stellt sicher, daß die in dem beschleunigten Schreibmodus geschriebenen Daten effektiv unbeschränkt - nämlich nur durch die Lebensdauer des Datenträgers begrenzt - verfügbar sind. Im Verhältnis zu der Zeiteinsparung durch die Verwendung des beschleunigten Schreibmodus fällt der Aufwand für den Auffrischungsvorgang in der Regel kaum ins Gewicht, weil auch der beschleunigte Schreibmodus schon eine verhältnismäßig lange Datenhaltezeit bereitstellt und daher nur relativ selten eine Auffrischung erforderlich ist.

In besonders vorteilhaften Ausführungsformen wird der beschleunigte Schreibmodus insbesondere für solche Daten genutzt, die beim weiteren Programmablauf voraussichtlich wieder überschrieben werden oder bei denen dies zumindest nicht ausgeschlossen werden kann. Je öfter eine Speicherzelle im Verhältnis zu der Anzahl der Auffrischungsvorgänge für diese Speicherzelle beschrieben wird, um so größer ist der durch die Verwendung des beschleunigten Schreibmodus erzielte Gewinn.

Besonders häufige Schreibvorgänge sind bei der Programmausführung in einer objektorientierten Laufzeitumgebung zu beobachten. Eine solche Laufzeitumgebung ist beispielsweise bei Datenträgern, die der *Java-Card*-Spezifikation entsprechen, als *Java Card Runtime Environment* (JCRE) vorhanden. Ausführliche Informationen zu *Java Cards* finden sich auf den Internet-Seiten der Firma Sun Microsystems, Inc., Palo Alto, USA, unter *http:*//*java.sun.com.*

Bei der Programmausführung in einer Java-Card-Laufzeitumgebung sind konzeptbedingt viele Schreibzugriffe zur Aktualisierung *(update)* von Objektfeldern erforderlich; die Objektfelder befinden sich ihrerseits in einem als Haldenspeicher (*heap*) bezeichneten Bereich des nicht-flüchtigen Speichers. Auch wenn häufige Zugriffe auf die Objektfelder auftreten, kann dennoch in der Regel nicht davon ausgegangen werden, daß jedes Objektfeld regelmäßig aktualisiert wird. Der erfindungsgemäße Auffrischungsvorgang ist daher erforderlich, um die Datensicherheit auch für Objektfelder zu garantieren, die während des Programmablaufs nur ein einziges Mal unter Verwendung des beschleunigten Schreibmodus beschrieben werden.

Vorzugsweise wird der nicht-flüchtige Speicher nicht ausschließlich unter Verwendung des beschleunigten Schreibmodus beschrieben. Vielmehr wird in bevorzugten Ausführungsformen für Daten, die voraussichtlich dauerhaft im nicht-flüchtigen Speicher verbleiben, der reguläre Schreibmodus verwendet. Solche Daten können beispielsweise Programme und Werte sein, die während der Initialisierung oder Personalisierung des Datenträgers in diesen geladen werden, oder Programme, die während des Betriebs des Datenträgers in diesen nachgeladen werden. Für derartige Daten ist kein Auffrischungsvorgang erforderlich; es sollen jedoch Ausführungsformen, die den gesamten nicht-flüchtigen Speicher auffrischen, vorzugsweise nicht ausgeschlossen werden.

Für den Auffrischungsvorgang wird in manchen Ausgestaltungen wieder der beschleunigte Schreibmodus verwendet. Dies ist insbesondere dann möglich, wenn die Auffrischung in regelmäßigen Abständen erfolgt. Vorzugsweise wird jedoch für den Auffrischungsvorgang der reguläre Schreibmodus eingesetzt. Dies hat den Vorteil, daß der dauerhafte Datenerhalt nach nur einer einzigen Auffrischung gesichert ist. Die für den regulären Schreibmodus benötigte Zeit ist hier von untergeordneter Bedeutung, weil die Auffrischung - im Vergleich zur Anzahl der Schreibvorgänge - nur selten ausgeführt werden muß.

Der Auffrischungsvorgang ist bevorzugt so ausgestaltet, daß er die normale Programmausführung des Datenträgers nicht oder nur geringfügig beeinträchtigt. Wenn der Datenträger eine Multitasking-Umgebung bereitstellt, kann der Auffrischungsvorgang insbesondere als Hintergrundprozeß ausgeführt werden. In anderen Ausgestaltungen kann vorgesehen sein, den Auffrischungsvorgang für jeweils eine Seite oder jeweils mehrere Seiten des nicht-flüchtigen Speichers bei jedem Hochfahren des Datenträgers oder bei jedem Empfang einer Anwendungsprotokoll-Dateneinheit (APDU - *application protocol data unit)* durchzuführen.

In bevorzugten Ausgestaltungen ist der nicht-flüchtige Speicher ein EEPROM-Speicher. Der nicht-flüchtige Speicher kann jedoch auch in anderen Technologien, z.B. als Flash-EEPROM, ausgestaltet sein, bei denen die Schreibzeit vergleichsweise lang ist und bei denen die Möglichkeit eines beschleunigten Schreibvorgangs mit verminderter Datenhaltezeit besteht.

In manchen Ausgestaltungen kann der Auffrischungsvorgang softwaregesteuert von einem Prozessor des Datenträgers ausgeführt werden. Beispielsweise kann eine Einheit des nicht-flüchtigen Speichers in einen Puffer gelesen und wieder an die ursprüngliche Stelle im nicht-flüchtigen Speicher zurückgeschrieben werden. In der Wortwahl des vorliegenden Dokuments ist unter einer "Einheit" in unterschiedlichen Ausgestaltungen entweder eine einzelne Speicherzelle oder eine Anordnung mehrerer Speicherzellen - beispielsweise ein Byte oder ein Wort oder eine Seite des nicht-flüchtigen Speichers - zu verstehen. Die Auffrischung kann auch hardwareunterstützt durch eine Auffrischschaltung erfolgen. Hierdurch verringert sich die Prozessorbelastung und/oder die benötigte Zeit. Je nach der Ausgestaltung der Hardwareunterstützung kann die Auffrischung vollständig oder teilweise parallel zu der eigentlichen Programmausführung ablaufen.

In bevorzugten Ausführungsformen ist eine Meßschaltung vorgesehen, um zu überprüfen, ob eine Einheit des nicht-flüchtigen Speichers aufgefrischt zu werden braucht oder nicht. Wenn sich der Ladungszustand der Speicherzelle oder der Speicherzellen einer Einheit innerhalb vorgegebener Grenzen bewegt, braucht keine Auffrischung vorgenommen zu werden. In Ausgestaltungen, bei denen die von der Meßschaltung überprüfte Einheit mehrere Speicherzellen umfaßt, kann die Meßschaltung entweder den Ladungszustand aller dieser Speicherzellen individuell auswerten oder eine Stichprobe vornehmen, die nur eine oder mehrere Speicherzellen der Einheit umfaßt.

Die Überprüfung des Ladungszustands kann in Zusammenhang mit dem Auffrischungsvorgang oder unabhängig von dem Auffrischungsvorgang erfolgen. So kann beispielsweise bei jedem Lesezugriff auf den nicht-flüchtigen Speicher gleichzeitig die Einheit, auf die zugegriffen wird, hinsichtlich ihres Ladungszustands überprüft werden. Alternativ oder zusätzlich kann eine Überprüfung als Hintergrundprozeß - vorzugsweise mit Hardwareunterstützung - oder bei jedem Hochfahren des Datenträgers erfolgen.

Wenn bei der Überprüfung festgestellt wird, daß eine Einheit des nicht-flüchtigen Speichers aufgefrischt werden muß, kann in bevorzugten Ausgestaltungen ein Merker *(flag)* gesetzt und/oder eine Unterbrechung (*interrupt*) ausgelöst werden. Im erstgenannten Fall wird der gesetzte Merker z.B. beim nächsten turnusmäßigen Auffrischungsvorgang erkannt, und die markierte Einheit wird aufgefrischt. Im zweitgenannten Fall erfolgt die Auffrischung im Zusammenhang mit der Unterbrechungsbehandlung, und zwar entweder softwaregesteuert oder ganz oder teilweise hardwareunterstützt.

Um fehlerhafte oder funktionsschwache Speicherzellen zu erkennen, ist in manchen Ausgestaltungen vorgesehen, daß aufgefrischte Einheiten des nicht-flüchtigen Speichers vermerkt werden. Wenn bei der nächsten Überprüfung festgestellt wird, daß eine so: vermerkte Einheit vorzeitig wieder aufgefrischt werden muß, kann dies als Anzeichen für einen Defekt oder eine Funktionsschwäche gewertet werden. Es können dann geeignete Schritte unternommen werden; insbesondere können die in den betroffenen Speicherzellen enthaltenen Daten in einen anderen Bereich des nicht-flüchtigen Speichers übertragen und dort weiter bearbeitet werden. In manchen Ausgestaltungen werden Speicherbereiche sogleich als defekt angesehen, wenn bei einer Überprüfung des Ladungszustands eine zu starke Abweichung von vorgegebenen Normwerten festgestellt wird.

Das erfindungsgemäße Computerprogrammprodukt weist Programmbefehle auf, um das erfindungsgemäße Speicherverfahren zu implementieren. Ein derartiges Computerprogrammprodukt kann ein körperliches Medium sein, beispielsweise ein Halbleiterspeicher oder eine Diskette oder eine CD-ROM. Das Computerprogrammprodukt kann jedoch auch ein nichtkörperliches Medium sein, beispielsweise ein.über ein Computernetzwerk übermitteltes Signal. Insbesondere kann das Computerprogrammprodukt bei der Herstellung oder der Initialisierung eines tragbaren Datenträgers eingesetzt werden.

In bevorzugten Ausgestaltungen weisen der Datenträger und/oder das Computerprogrammprodukt Merkmale auf, die den gerade beschriebenen und/oder den in den abhängigen Verfahrensansprüchen genannten Merkmalen entsprechen.

Weitere Merkmale, Vorteile und Aufgaben der Erfindung gehen aus der folgenden genauen Beschreibung mehrerer Ausführungsbeispiele und Ausführungsalternativen hervor. Es wird auf die schematischen Zeichnungen verwiesen, in denen zeigen:
Fig. 1 ein Blockdiagramm mit Funktionseinheiten eines tragbaren Datenträgers nach einem Ausführungsbeispiel der Erfindung,
Fig. 2 eine schematische Ablaufdarstellung von Schreib- und Auffrischungsvorgängen,
Fig. 3 ein Flußdiagramm eines Verfahrens zur Bestimmung der nächsten aufzufrischenden Speicherseite als Teil das Ablaufs von Fig. 2,
Fig. 4 ein beispielhaftes Diagramm des zeitlichen Ablaufs der Ladungserhaltung in einer EEPROM-Speicherzelle,
Fig. 5 eine Darstellung eines Teils des Datenträgers von Fig. 1 in einer Ausführungsalternative,
Fig. 6 ein gegenüber Fig. 3 abgewandeltes Flußdiagramm zur Verwendung in der Ausführungsalternative gemäß Fig. 5, und
Fig. 7 und Fig. 8 je eine Darstellung eines Teils des Datenträgers von Fig. 1 in zwei weiteren Ausführungsalternativen.

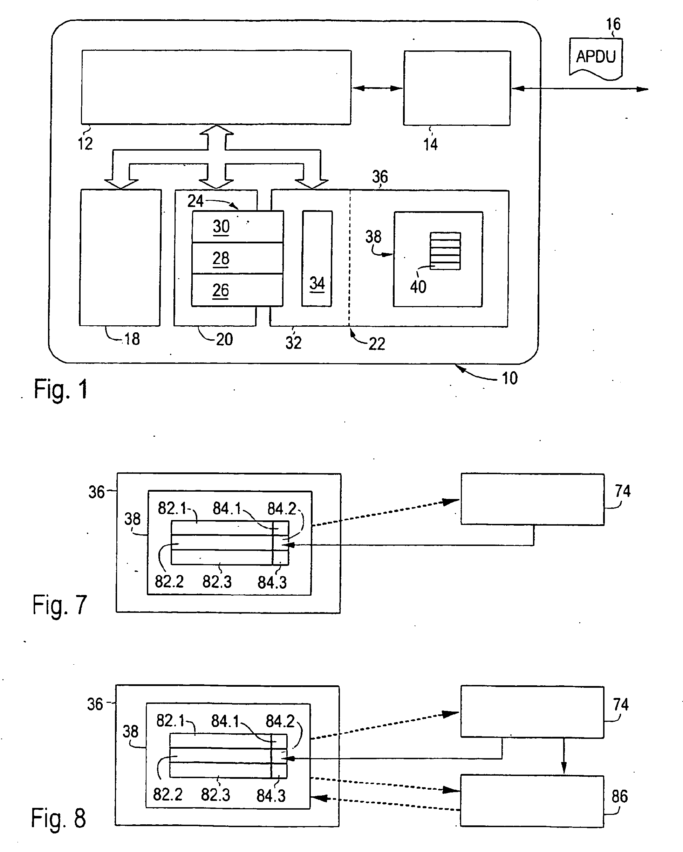

Der in Fig. 1 dargestellte Datenträger 10 ist im vorliegenden Ausführungsbeispiel als Chipkarte gemäß dem *Java*-*Card*-Standard ausgestaltet. Der Datenträger 10 weist auf einem einzigen Halbleiterchip einen Prozessor 12, mehrere in unterschiedlichen Technologien ausgestaltete Speicherfelder und eine Schnittstellenschaltung 14 auf. Die Schnittstellenschaltung 14 dient zur kontaktlosen oder kontaktgebundenen Übermittlung von Anwendungsprotokoll-Dateneinheiten (APDUs) 16 zwischen dem Datenträger 10 und einem in Fig. 1 nicht gezeigten Terminal.

Im vorliegenden Ausführungsbeispiel sind als Speicherfelder des Datenträgers 10 ein Arbeitsspeicher 18, ein Festwertspeicher 20 und ein beschreibbarer, nicht-flüchtiger Speicher 22 vorgesehen. Der Arbeitsspeicher 18 ist als RAM, der Festwertspeicher 20 als maskenprogrammiertes ROM und der nicht-flüchtige Speicher 22 als elektrisch lösch- und programmierbares EEPROM ausgestaltet. Der nicht-flüchtige Speicher 22 ist in Speicherseiten untergliedert; jede Seite kann z.B. 8 oder 16 Bytes aufweisen. Weiter unterstützt der nicht-flüchtige Speicher 22 einen regulären und einen beschleunigten Schreibmodus. Der beschleunigte Schreibmodus nimmt erheblich weniger Zeit in Anspruch als der reguläre Schreibmodus. Für beschleunigt geschriebene Daten weist der nicht-flüchtige Speicher 22 jedoch nur eine garantierte Datenhaltezeit auf, die kürzer als die erwartete Lebensdauer des Datenträgers 10 ist.

) Im Festwertspeicher 20 - und zum Teil auch im nicht-flüchtigen Speicher 22 - sind Systemprogramme 24 enthalten. In an sich bekannter Weise umfassen die Systemprogramme 24 ein Betriebssystem 26, das eine Vielzahl von hardwarenahen Funktionen und Diensten bereitstellt. Ein Codemodul 28 implementiert eine virtuelle Maschine, und zwar im vorliegenden Ausführungsbeispiel eine JCVM *(Java Card Virtual Machine).* Eine Klassenbibliothek 30 enthält eine Reihe vordefinierter Anwendungsprogrammierschnittstellen.

In ihrem Zusammenwirken stellen die Systemprogramme 24 eine Laufzeitumgebung zur Ausführung von Anwendungsprogrammen dar. Diese Laufzeitumgebung ist im vorliegenden Ausführungsbeispiel ein JCRE (*Java Card Runtime Environment),* und die Anwendungsprogramme sind Applets, die in Form von ausführbarem Bytecode in den nicht-flüchtigen Speicher 22 geladen wurden. Da dieser Ladevorgang wenig zeitkritisch ist, wurden die Anwendungsprogramme und sonstige Daten, die sich während der Lebensdauer des Datenträgers voraussichtlich nicht verändern, unter Verwendung des regulären Schreibmodus in den nicht-flüchtigen Speicher 22 geschrieben. Eine Auffrischung dieser Daten ist nicht erforderlich. Fig. 1 zeigt beispielhaft einen Bereich 32 des nicht-flüchtigen Speichers 22, für den kein Auffrischungsvorgang vorgesehen ist, und ein in diesen Bereich 32 dauerhaft eingeschriebenes Anwendungsprogramm 34.

Ein weiterer Bereich 36 des nicht-flüchtigen Speichers 22 ist für Daten vorgesehen, die sich während der Lebensdauer des Datenträgers 10 voraussichtlich ändern werden oder über deren Bestandszeit zumindest keine Aussage gemacht werden kann. Insbesondere ist in diesem Bereich 36 ein Haldenspeicher (*heap*) 38 angelegt, in dem Objektfelder und sonstige persistente Datenstrukturen der Java-Card-Laufzeitumgebung angelegt werden. Eines dieser Objektfelder ist in Fig. 1 beispielhaft mit dem Bezugszeichen 40 gezeigt.

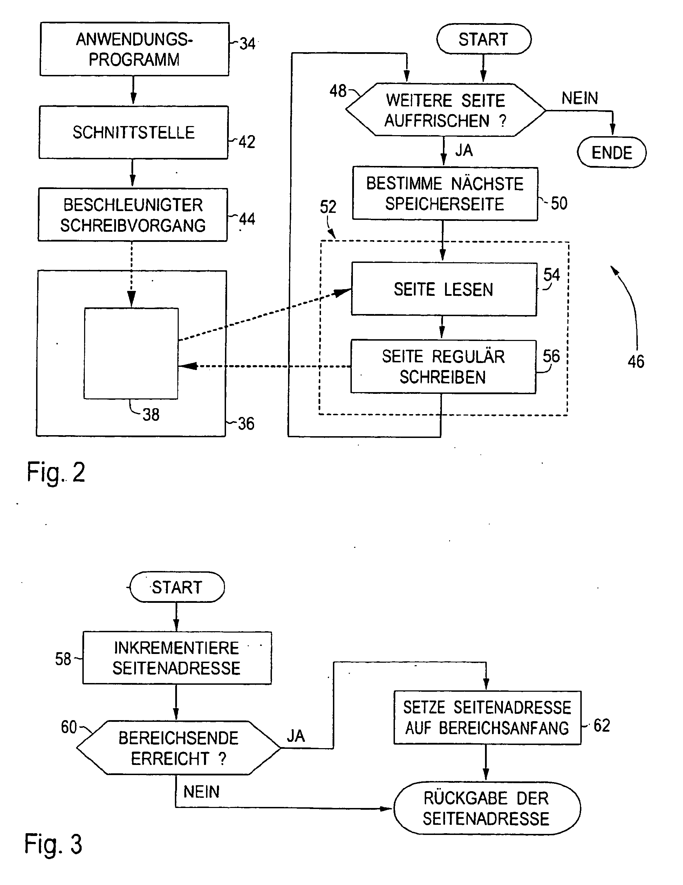

Konzeptbedingt werden während der Ausführung des Anwendungsprogramms 34 eine Vielzahl von Schreibzugriffen auf den Haldenspeicher 38 - z.B. zur Aktualisierung des Objektfelds 40 und anderer Objektfelder - ausgeführt. Ein wesentliches Merkmal der vorliegenden Erfindung ist es, daß für diese Schreib- oder Aktualisierungszugriffe stets der beschleunigte Schreibmodus verwendet wird. Dies ist auf der linken Seite von Fig. 2 dargestellt. Das Anwendungsprogramm 34 führt hier über eine Schnittstelle 42, die von den Systemprogrammen 24 bereitgestellt wird, einen beschleunigten Schreibvorgang 44 auf den im Speicherbereich 36 angelegten Haldenspeicher 38 aus. Wegen der Häufigkeit dieser Schreibzugriffe wird durch die Verwendung des beschleunigten Schreibmodus die Gesamtleistung des Datenträgers 10 bedeutend gesteigert.

In der Regel kann vorab keine Aussage darüber gemacht werden, ob eine im beschleunigten Schreibmodus beschriebene Speicherzelle des nicht-flüchtigen Speichers 22 vor Ablauf der garantierten Datenhaltezeit wieder überschrieben und damit aufgefrischt wird. Es ist daher ein Auffrischungsvorgang für den Speicherbereich 36 vorgesehen. Ein beispielhafter Ablauf dieses Auffrischungsvorgangs ist auf der rechten Seite von Fig. 2 mit dem Bezugszeichen 46 dargestellt.

Der Auffrischungsvorgang 46 läuft im Hintergrund ab. In dem in Fig. 2 gezeigten Ausführungsbeispiel ist der Auffrischungsvorgang ein Hintergrundprozeß, der von einer durch die Programmausführungsumgebung bereitgestellten Multitasking-Prozeßverwaltung regelmäßig angestoßen wird. In anderen Ausgestaltungen - insbesondere bei Datenträgern 10, die keine Multitasking-Umgebung bieten - wird dagegen der Auffrischungsvorgang 46 bei jedem Hochfahren des Datenträgers 10 durchgeführt oder von einem geeigneten Ereignis, beispielsweise dem Empfang einer Anwendungsprotokoll-Dateneinheit 16 oder einem Zeitgeber-Ereignis, ausgelöst.

Allgemein werden bei jedem Anstoß des Auffrischungsvorgangs 46 eine vorbestimmte Anzahl von Speicherzellen überprüft und/oder aufgefrischt. Insbesondere kann diese Auffrischung seitenweise erfolgen; es kann beispielsweise vorgesehen sein, bei jedem Aufruf des Auffrischungsvorgangs 46 eine Speicherseite oder allgemein n Speicherseiten aufzufrischen. Im Extremfall - insbesondere dann, wenn der Auffrischungsvorgang im Zusammenhang mit dem Hochfahren des Datenträgers 10 ausgeführt wird - kann auch vorgesehen sein, alle Speicherseiten im Bereich 36 aufzufrischen.

In Schritt 48 wird zunächst überprüft, ob im Rahmen des aktuellen Auffrischungsvorgangs 46 eine weitere Speicherseite aufgefrischt werden soll. Unmittelbar nach dem Anstoß des Auffrischungsvorgangs 46 wird diese Überprüfung in Schritt 48 immer mit dem Ergebnis "Ja" enden. Nach der entsprechenden Anzahl von Durchläufen ergibt die Überprüfung in Schritt 48 dann jedoch das Ergebnis "Nein", und der Auffrischungsvorgang 46 wird - bis zum nächsten Anstoß durch das Betriebssystem oder durch ein externes Ereignis - beendet.

In Schritt 50 wird die Adresse der nächsten aufzufrischenden Speicherseite bestimmt. Hierfür sind mehrere Strategien möglich, auf die im folgenden genauer eingegangen werden wird. Es folgt die eigentliche Auffrischung 52 einer Speicherseite. In dem in Fig. 2 gezeigten Ausführungsbeispiel ist die Auffrischung 52 softwaremäßig implementiert, indem die aufzufrischende Speicherseite zunächst in Schritt 54 vom Prozessor 12 gelesen und in einen Puffer im Arbeitsspeicher 18 geschrieben wird. Die Daten werden dann in Schritt 56 an die ursprüngliche Stelle im nicht-flüchtigen Speicher 22 zurückgeschrieben. Hierbei muß ein gesicherter - z.B. atomarer - Schreibvorgang ausgeführt werden, um sicherzustellen, daß bei einem plötzlichen Ausfall der Versorgungsspannung des Datenträgers 10 keine inkonsistenten Daten im nicht-flüchtigen Speicher 22 verbleiben. Der Schreibvorgang in Schritt 56 wird im vorliegenden Ausführungsbeispiel unter Verwendung des regulären Schreibmodus durchgeführt, während in Ausführungsalternativen auch der beschleunigte Schreibmodus eingesetzt werden kann.

In dem Ausführungsbeispiel von Fig. 2 erfolgt die Auffrischung 52 softwaregesteuert unter Kontrolle des Prozessors 12. In Ausführungsalternativen kann jedoch eine Auffrischschaltung zur Beschleunigung dieses Vorgangs und/ oder Entlastung des Prozessors 12 vorgesehen sein. Die Funktionsweise einer solchen Auffrischschaltung wird unten im Zusammenhang mit Fig. 8 noch genauer erläutert werden.

Fig. 3 zeigt eine besonders einfache Strategie zur Bestimmung der nächsten aufzufrischenden Speicherseite in Schritt 50, bei der der gesamte Bereich 36 zyklisch durchlaufen wird. Genauer gesagt, wird in Schritt 58 die Adresse der letzten aufgefrischten Speicherseite inkrementiert. Diese Adresse wird verwendet, wenn sie sich noch innerhalb des Bereichs 36 befindet ("Nein"-Zweig von Schritt 60). Hat die neue Adresse jedoch den Bereich 36 verlassen ("Ja"-Zweig von Schritt 60), so wird sie in Schritt 62 auf eine Anfangsadresse des Bereichs 36 zurückgesetzt.

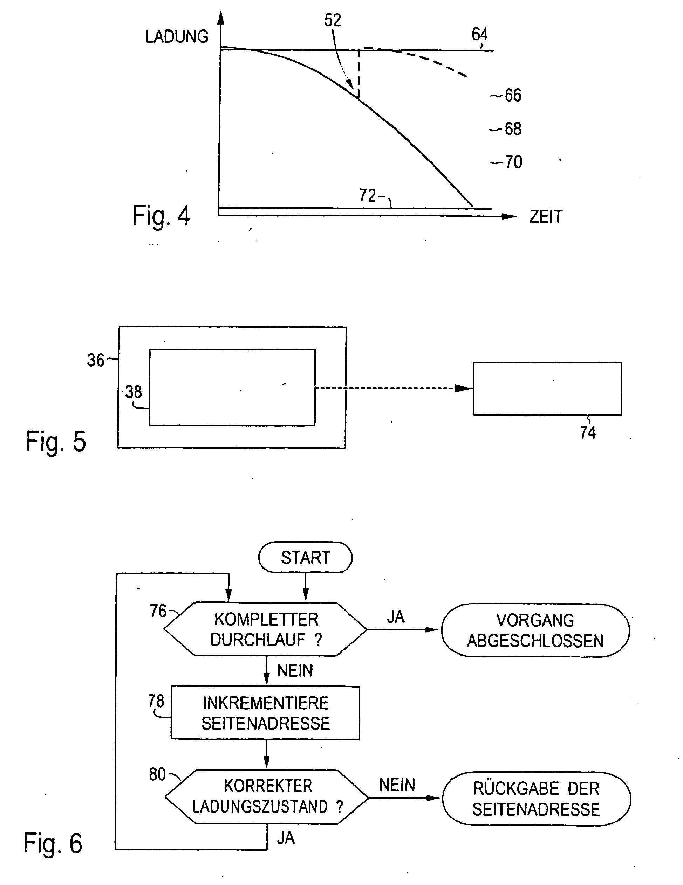

In den bisher beschriebenen Ausführungsbeispielen erfolgte die Auffrischung unabhängig vom aktuellen Ladungszustand der betroffenen Speicherzellen. Die durchgezogene Kurve in Fig. 4 zeigt beispielhaft einen typischen Ladungsverlauf einer Speicherzelle im Verlauf mehrerer Jahre, wenn keine Auffrischung erfolgt. Ausgehend von einem Normwert 64, der eine voll geladene Speicherzelle repräsentiert, sinkt die Ladung durch Isolationsverluste und quantenmechanische Effekte zunächst in einen Warnbereich 66 und dann in einen undefinierten Bereich 68. Der Ladungszustand erreicht schließlich einen Warnbereich 70 und gegebenenfalls einen Normwert 72, die dem invertierten ursprünglichen Datenwert der Speicherzelle entsprechen. Die Zeitdauer der Entladung hängt unter anderem von Faktoren wie der Temperatur und der Belastung der Speicherzelle (Anzahl der Schreibvorgänge) ab.

Solange der Ladungszustand der in Fig. 4 gezeigten Speicherzelle noch nahe bei dem ursprünglichen Normwert 64 ist, wäre eine Auffrischung 52 nur unnötiger Aufwand. Es ist daher in den im folgenden beschriebenen Ausgestaltungen vorgesehen, im Zusammenhang mit dem Auffrischungsvorgang 46 den aktuellen Ladungszustand der betrachteten Speicherzellen zu messen und die eigentliche Auffrischung 52 erst dann durchzuführen, wenn der Warnbereich 66 erreicht ist. Dies ist in Fig. 4 durch eine gestrichelte Ladungskurve angedeutet. Übrigens kann auch bei einer ursprünglich entladenen Speicherzelle eine allmähliche Aufladung zu beobachten sein, insbesondere dann, wenn benachbarte Zellen einen geladenen Zustand aufweisen. In bevorzugten Ausgestaltungen wird daher auch dann eine Auffrischung als erforderlich erachtet, wenn der Ladungszustand einer ursprünglich entladenen Speicherzelle den Warnbereich 70 erreicht.

Fig. 5 zeigt schematisch den Haldenspeicher 38 im Bereich 36 des nicht-flüchtigen Speichers, der mit einer Meßschaltung 74 zur Ermittlung des Ladungszustands von Einheiten des nicht-flüchtigen Speichers verbunden ist. Im hier beschriebenen Ausführungsbeispiel sind diese Einheiten Speicherseiten, während in anderen Ausgestaltungen eine andere Einheitengröße - von einer einzigen Speicherzelle aufwärts - vorgesehen sein kann. Im vorliegenden Ausführungsbeispiel ist die Meßschaltung 74 so ausgestaltet, daß sie für jede Speicherzelle innerhalb der aktuellen Speicherseite einzeln überprüft, ob der Ladungszustand der Speicherzelle den Warnbereich 66 bzw. 70 erreicht hat. In Ausführungsalternativen wird dagegen für jede Speicherseite nur eine stichprobenhafte Überprüfung anhand einer oder mehrerer Speicherzellen dieser Seite vorgenommen. Dies verringert den für die Meßschaltung 74 erforderlichen Aufwand und kann insbesondere dann ausreichend sein, wenn der nicht-flüchtige Speicher ausschließlich seitenweise beschrieben wird.

Fig. 6 zeigt eine Ausgestaltung der in Schritt 50 (Fig. 2) aufgerufenen Routine zur Bestimmung der nächsten aufzufrischenden Speicherseite, und zwar eine Ausgestaltung mit Ladungszustandsüberwachung. In Schritt 76 wird zunächst überprüft, ob der Bereich 36 beim aktuellen Aufruf der Routine bereits vollständig durchlaufen wurde. Ein vollständiger Durchlauf zeigt an, daß alle Speicherseiten im Bereich 36 einen akzeptablen Ladungszustand aufweisen und daher keine Auffrischung erforderlich ist. In diesem Fall ("Ja"-Zweig von Schritt 76) wird der Auffrischungsvorgang 46 beendet. Sind dagegen noch Speicherseiten im Bereich 36 zu überprüfen ("Nein"-Zweig von Schritt 76), so wird in Schritt 78 die aktuelle Seitenadresse inkrementiert und bei einer Überschreitung der Bereichsgrenzen wieder auf einen Anfangswert zurückgesetzt, wie dies in Fig. 3 gezeigt ist.

In Schritt 80 wertet die Meßschaltung 74 nun den Ladungszustand der durch die neue Adresse bezeichneten Speicherseite aus. Ist dieser Ladungszustand für alle - oder zumindest alle geprüften - Speicherzellen nahe genug an den Normwerten 64 bzw. 72, so wird die Suche fortgesetzt ("Ja"-Zweig von Schritt 80). Andernfalls ("Nein"-Zweig von Schritt 80) wird die Adresse der als auffrischungsbedürftig ermittelten Speicherseite zur Auffrischung 52 zurückgegeben.

Das gerade beschriebene Verfahren mit einer Ladungszustandsüberprüfung benötigt in der Regel - nämlich dann, wenn keine Auffrischung erforderlich ist - relativ wenig Zeit. Es kann daher - alternativ oder zusätzlich zu dem bereits beschriebenen Auffrischungsvorgang im Hintergrundbetrieb - vorteilhaft bei jedem Hochfahren des Datenträgers 10 oder in Reaktion auf andere externe Ereignisse ausgeführt werden. In weiteren Ausführungsalternativen kann die Meßschaltung 74 unabhängig von dem Auffrischungsvorgang 46 bei allen Lesezugriffen auf den nicht-flüchtigen Speicher 22 - oder zumindest auf den Bereich 36 - zur Ladungszustandsüberwachung eingesetzt werden. Eine entsprechende Ausgestaltung ist in Fig. 7 dargestellt.

Fig. 7 zeigt beispielhaft einige Speicherseiten 82.1, 82.2, 82.3 des nicht-flüchtigen Speichers 22, die im folgenden zusammenfassend mit 82.x bezeichnet werden. Jeder Speicherseite 82.x ist ein zusätzliches Bit als Merker *(flag)* 84.1, 84.2, 84.3 - zusammenfassend mit 84.x bezeichnet - zugeordnet. Die Meßschaltung 74 überwacht während der normalen Programmausführung im Datenträger 10 bei jedem Zugriff auf eine Speicherseite 82.x deren Ladungszustand auf die oben beschriebene Weise. Wird hierbei festgestellt, daß eine Auffrischung der Speicherseite 82.x erforderlich ist, so setzt die Meßschaltung 74 den der Speicherseite 82.x zugeordneten Merker 84.x. Bei dem nächsten Auffrischungsvorgang 46 werden die Merker 84.x abgefragt, um zu bestimmen, welche Speicherseiten 82.x aufgefrischt werden müssen. In Abwandlungen können statt der Speicherseiten 82.x andere Einheiten des nicht-flüchtigen Speichers 22 überwacht und gegebenenfalls als auffrischungsbedürftig markiert werden.

In einer gegenüber Fig. 7 abgewandelten Ausführungsform wird, wenn die Meßschaltung 74 eine aufzufrischende Speicherseite 82.x erkennt, eine Unterbrechung *(interrupt)* ausgelöst. Im Rahmen der Unterbrechungsbehandlung kann entweder sogleich die Auffrischung 52 vorgenommen werden, oder es können Adreßinformationen über die aufzufrischende Seite 82.x oder die aufzufrischenden Seiten 82.x abgelegt werden. Diese Adreßinformationen werden dann beim nächsten Auffrischungsvorgang 46 ausgewertet. Statt oder zusätzlich zu der Auslösung einer Unterbrechung kann auch unmittelbar eine hardwaregestützte Auffrischung mittels einer Auffrischschaltung erfolgen.

Statt oder zusätzlich zu der Überwachung von Lesezugriffen kann in weiteren Ausführungsalternativen die Meßschaltung 74 eine hardwaregestützte Ladungszustandsüberwachung des gesamten nicht-flüchtigen Speichers 22 - oder zumindest des Bereich 36 - durchführen. Hierbei weist die Meßschaltung 74 einen Zähler auf, der zyklisch alle zu überprüfenden Speicheradressen durchläuft. Vorzugsweise sind in diesem Fall die Speicherzugriffe der Meßschaltung 74 derart mit Speicherzugriffen des Prozessors 12 verschachtelt, daß die für den Prozessor 12 zur Verfügung stehende Speicherbandbreite nicht oder nur geringfügig eingeschränkt wird. Auch bei derartigen Ausgestaltungen kann eine erforderliche Auffrischung einer Speicherseite 82.x entweder durch Setzen des entsprechenden Merkers 84.x oder durch Auslösen einer Unterbrechung angefordert oder sogleich mittels einer zusätzlichen Auffrischschaltung ausgeführt werden.

Fig. 8. zeigt eine weitere Ausführungsalternative, bei der die bereits mehrfach als Möglichkeit erwähnte Auffrischschaltung 86 vorgesehen ist. Die Meßschaltung 74 überwacht hier Speicherseiten 82.x, die vom Prozessor 12 und/oder von der Meßschaltung 74 angesprochen werden, hinsichtlich ihres Ladungszustands. Eine als erforderlich erkannte Auffrischung wird unmittelbar von der Auffrischschaltung 86 durchgeführt.

Ein gesetzter Merker 84.x in dem Ausführungsbeispiel gemäß Fig. 8 zeigt nicht eine Auffrischanforderung, sondern eine bereits durchgeführte Auffrischung an. Immer wenn die Auffrischschaltung 86 oder der Prozessor 12 eine Speicherseite 82.x auffrischen, wird der zugeordnete Merker 84.x gesetzt. Wenn die Meßschaltung 74 beim nächsten Überprüfungsdurchlauf feststellt, daß eine Speicherseite 82.x mit gesetztem Merker 84.x wieder auffrischungsbedürftig ist, wird dies als Indiz dafür gewertet, daß die Speicherseite 82.x leistungsschwach ist und sich dem Ende ihrer Lebensdauer nähert. Das Betriebssystem des Datenträgers 10 vermerkt daraufhin diese Speicherseite 82.x als defekt. Gegebenenfalls in der Speicherseite 82.x enthaltene Daten werden an eine andere Stelle kopiert, und die Speicherseite 82.x wird nicht mehr verwendet. Es versteht sich, daß der Merker 84.x zurückgesetzt werden muß, wenn ein beschleunigter Schreibvorgang auf die entsprechende Speicherseite 82.x erfolgt, weil in diesem Fall eine später erforderliche Auffrischung keine Fehlfunktion oder Leistungsschwäche der in der Speicherseite 82.x enthaltenen Speicherzellen anzeigt.

Die Meßschaltung 74 meldet dem Betriebssystem des Datenträgers 10 ferner solche Seiten 82.x als defekt, deren Ladungszustand nicht mehr eindeutig zuordenbar ist, weil er sich innerhalb des undefinierten Bereichs 68 befindet. Auch solche Seiten 82.x werden wie gerade beschrieben behandelt.

Wie bereits erwähnt, kann die in Fig. 8. gezeigte Auffrischschaltung 86 auch mit den oben beschriebenen Ausführungsvarianten kombiniert werden und ferner im Zusammenhang mit dem softwaregesteuerten Auffrischungsvorgang 46 (Fig. 2) eingesetzt werden. Ein Vorteil bei der Verwendung der Auffrischschaltung 86 ist, daß der relativ zeitaufwendige Vorgang des Lesens von Daten aus dem nicht-flüchtigen Speicher 22 und des Wiedereinschreibens der Daten in ein Programmierregister des nicht-flüchtigen Speichers 22 entfällt. Vielmehr kann die Auffrischschaltung 86 die in einer Speicherseite 82.x enthaltenen Daten unmittelbar vom Ausgang des nicht-flüchtigen Speichers 22 in dessen Programmierregister übertragen.

Es versteht sich, daß die einzelnen Aspekte der oben beschriebenen Ausführungsbeispiele in unterschiedlicher Weise miteinander kombiniert werden können. So kann beispielsweise die Speicherung von Auffrischungsanforderungen in Merkern gemäß Fig. 7 mit einer Überwachung der Datenhaltezeit gemäß Fig. 8 kombiniert werden, wenn jeder Speicherseite zwei Merker zugeordnet sind. Ferner können alle oben beschriebenen Vorgänge statt auf Grundlage von Speicherseiten auch auf Grundlage anderer Einheiten des nicht-flüchtigen Speichers - z.B. Speicherworten oder Bytes oder einzelnen Speicherzellen - durchgeführt werden. Eine Vielzahl weiterer Kombinationen und Abwandlungen der hier beispielhaft beschriebenen Ausgestaltungen ist vorgesehen und für den Fachmann offensichtlich.

## Patentansprüche

1. Verfahren zum Speichern von Daten in einem nicht-flüchtigen Speicher (22) eines tragbaren Datenträgers (10), wobei der nichtflüchtige Speicher (22) einen regulären Schreibmodus und einen beschleunigten Schreibmodus mit verringerter Datenhaltezeit unterstützt, **dadurch gekennzeichnet, daß** die zu speichernden Daten wahlweise als erste Daten unter Verwendung des beschleunigten Schreibmodus in den nicht-flüchtigen Speicher geschrieben werden (44), wobei zu mindestens einem späteren Zeitpunkt ein Auffrischungsvorgang (46) für die ersten Daten durchgeführt wird, oder als zweite Daten unter Verwendung des regulären Schreibmodus in den nicht-flüchtigen Speicher geschrieben werden.

2. Verfahren nach Anspruch 1, **dadurch gekennzeichnet, daß** im nicht-flüchtigen Speicher (22) mindestens ein Bereich (32) für die zweiten Daten vorgesehen ist, die unter Verwendung des regulären Schreibmodus in den nicht-flüchtigen Speicher (22) geschrieben werden, und daß für die zweiten Daten kein Auffrischungsvorgang vorgesehen ist.

3. Verfahren nach Anspruch 1 oder Anspruch 2, **dadurch gekennzeichnet, daß** bei dem Auffrischungsvorgang (46) die ersten Daten unter Verwendung des regulären Schreibmodus in den nicht-flüchtigen Speicher geschrieben werden (56).

4. Verfahren nach einem der Ansprüche 1 bis 3, **dadurch gekennzeichnet, daß** der Auffrischungsvorgang (46) als Hintergrundprozeß in einer Multitasking-Umgebung ausgeführt wird, und/oder daß der Auffrischungsvorgang (46) durch den Empfang einer Anwendungsprotokoll-Dateneinheit (16) angestoßen wird, und/oder daß der Auffrischungsvorgang (46) beim Hochfahren des Datenträgers (10) durchgeführt wird.

5. Verfahren nach einem der Ansprüche 1 bis 4, **dadurch gekennzeichnet, daß** die unter Verwendung des beschleunigten Schreibmodus in den nicht-flüchtigen Speicher (22) geschriebenen ersten Daten solche sind, die während des weiteren Betriebs des Datenträgers (10) möglicherweise oder voraussichtlich überschrieben werden.

6. Verfahren nach einem der Ansprüche 1 bis 5, **dadurch gekennzeichnet, daß** die unter Verwendung des beschleunigten Schreibmodus in den nicht-flüchtigen Speicher (22) geschriebenen ersten Daten Objektfelder (40) in einer objektorientierten Programmausführungsumgebung umfassen.

7. Verfahren nach einem der Ansprüche 1 bis 6, **dadurch gekennzeichnet, daß** der Datenträger (10) eine *Java Card* ist, und daß die unter Verwendung des beschleunigten Schreibmodus in den nicht-flüchtigen Speicher (22) geschriebenen ersten Daten zumindest zum Teil in einen Haldenspeicher (38) einer *Java-Card-*Laufzeitumgebung geschrieben werden.

8. Verfahren nach einem der Ansprüche 1 bis 7, **dadurch gekennzeichnet, daß** der Datenträger (10) eine Meßschaltung (74) aufweist, welche überprüft, ob im Hinblick auf den aktuellen Ladungszustand einer Einheit des nicht-flüchtigen Speichers (22) eine Auffrischung erforderlich ist.

9. Verfahren nach Anspruch 8, **dadurch gekennzeichnet, daß** die Überprüfung im Zusammenhang mit dem Auffrischungsvorgang (46) und/ oder in einem von dem Auffrischungsvorgang (46) unabhängigen Hintergrundprozeß und/oder bei Lesezugriffen auf den nicht-flüchtigen Speicher (22) und/ oder beim Hochfahren des Datenträgers (10) erfolgt.

10. Verfahren nach Anspruch 8 oder Anspruch 9, **dadurch gekennzeichnet, daß** eine bei der Überprüfung als erforderlich erkannte Auffrischung einer Einheit des nicht-flüchtigen Speichers (22) durch Setzen eines Merkers (84.x) und/oder Auslösen einer Unterbrechung angezeigt wird.

11. Verfahren nach einem der Ansprüche 8 bis 10, **dadurch gekennzeichnet, daß** aufgefrischte Einheiten des nicht-flüchtigen Speichers (22) vermerkt werden, und daß solche Einheiten, wenn bei einer folgenden Überprüfung wiederum eine Auffrischung als erforderlich gehalten wird, als defekt behandelt werden.

12. Verfahren nach einem der Ansprüche 8 bis 11, **dadurch gekennzeichnet, daß** eine Einheit des nicht-flüchtigen Speichers (22) als defekt behandelt wird, wenn bei der Überprüfung dieser Einheit ein zu weit von Normwerten (64, 72) abweichender Ladungszustand festgestellt wird.

13. Verfahren nach einem der Ansprüche 8 bis 12, **dadurch gekennzeichnet, daß** die Auffrischung einer Einheit des nicht-flüchtigen Speichers (22) durch eine Auffrischschaltung (86) erfolgt.

14. Computerprogrammprodukt, das Programmbefehle aufweist, die einen Prozessor (12) eines tragbaren Datenträgers (10) zur Ausführung eines Verfahrens nach einem der Ansprüche 1 bis 13 veranlassen.

15. Tragbarer Datenträger (10), insbesondere Chipkarte oder Chipmodul, mit einem Prozessor (12) und mindestens einem Speicher (18,20, 22), wobei der Speicher (18, 20, 22) Programmbefehle enthält, die den Prozessor (12) zur Ausführung eines Verfahrens nach einem der Ansprüche 1 bis 13 veranlassen.

## Claims

1. A method of storing data in a non-volatile memory (22) of a portable data carrier (10), wherein the non-volatile memory (22) supports a regular writing mode and an accelerated writing mode with reduced data-retention time, **characterised in that** the data to be stored are either written in the non-volatile memory as first data using the accelerated writing mode (44), wherein at at least a later time a refreshing procedure (46) for the first data is carried out, or are written in the non-volatile memory as second data using the regular writing mode.

2. A method according to Claim 1, **characterised in that** in the non-volatile memory (22) there is provided at least one region (32) for the second data which are written in the non-volatile memory (22) using the regular writing mode, and **in that** no refreshing procedure is provided for the second data.

3. A method according to Claim 1 or Claim 2, **characterised in that** during the refreshing procedure (46) the first data are written (56) in the non-volatile memory using the regular writing mode.

4. A method according to any one of Claims 1 to 3, **characterised in that** the refreshing procedure (46) is carried out as a background process in a multitasking environment, and/or in that the refreshing procedure (46) is initiated by the receipt of an application protocol data unit (16), and/or **in that** the refreshing procedure (46) is carried out during the starting-up of the data carrier (10).

5. A method according to any one of Claims 1 to 4, **characterised in that** the first data written in the non-volatile memory (22) using the accelerated writing mode are those which are possibly or probably overwritten during the further operation of the data carrier (10).

6. A method according to any one of Claims 1 to 5, **characterised in that** the first data written in the non-volatile memory (22) using the accelerated writing mode comprise object fields (40) in an object-oriented program-execution environment.

7. A method according to any one of Claims 1 to 6, **characterised in that** the data carrier (10) is a *Java Card,* and **in that** the first data written in the non-volatile memory (22) using the accelerated writing mode are written at least partly in a heap memory (38) of a *Java Card* run time environment.

8. A method according to any one of Claims 1 to 7, **characterised in that** the data carrier (10) has a measuring circuit (74) which verifies whether refreshing is necessary with regard to the actual charge state of a unit of the non-volatile memory (22).

9. A method according to Claim 8, **characterised in that** the verification takes place in connection with the refreshing procedure (46) and/or in a background process independent of the refreshing procedure (46) and/or when performing read accesses to the non-volatile memory (22) and/or when starting up the data carrier (10).

10. A method according to Claim 8 or Claim 9, **characterised in that** a refreshing operation of a unit of the non-volatile memory (22) recognised as being necessary during the verification is indicated by a setting a marker (84.x) and/or triggering an interrupt.

11. A method according to any one of Claims 8 to 10, **characterised in that** refreshed units of the non-volatile memory (22) are noted, and **in that** such units are treated as defective if, during a subsequent verification, refreshing is again considered to be necessary.

12. A method according to any one of Claims 8 to 11, **characterised in that** a unit of the non-volatile memory (22) is treated as defective if, during a verification of this unit, a charge state deviating from standard values (64,72) is detected.

13. A method according to any one of Claims 8 to 12, **characterised in that** the refreshing of one unit of the non-volatile memory (22) is carried out by a refreshing circuit (86).

14. A computer program product which has program instructions which cause a processor (12) of a portable data carrier (10) to carry out a method according to any one of Claims 1 to 13.

15. A portable data carrier (10), in particular a chip card or chip module, with a processor (12) and at least one memory (18,20,22), wherein the memory (18,20,22) contains program instructions which cause the processor (12) to carry out a method according to any one of Claims 1 to 13.

## Revendications

1. Procédé pour stocker des données dans une mémoire (22) non-volatile d'un support de données (10) portable, la mémoire (22) non-volatile supportant un mode d'écriture régulier et un mode d'écriture accéléré avec un temps de maintien de données réduit, **caractérisé en ce que** les données à stocker sont inscrites au choix comme premières données en utilisant le mode d'écriture accéléré dans la mémoire non-volatile (44), une opération de rafraîchissement (46) étant effectuée pour les premières données à au moins un moment ultérieur, ou sont inscrites sous forme de secondes données en utilisant le mode d'écriture régulier dans la mémoire non-volatile.

2. Procédé selon la revendication 1, **caractérisé en ce que** dans la mémoire (22) non-volatile est prévue au moins une zone (32) pour les secondes données qui sont inscrites en utilisant le mode d'écriture régulier dans la mémoire (22) non-volatile, et **en ce qu'**aucune opération de rafraîchissement n'est prévue pour les secondes données.

3. Procédé selon la revendication 1 ou la revendication 2, **caractérisé en ce que**, lors d'une opération de rafraîchissement (46), les premières données sont inscrites dans la mémoire non-volatile en utilisant le mode d'écriture régulier (56).

4. Procédé selon l'une quelconque des revendications 1 à 3, **caractérisé en ce que** l'opération de rafraîchissement (46) est réalisée comme processus d'arrière-plan dans un environnement multitâches et/ou l'opération de rafraîchissement (46) est déclenchée par la réception d'une unité de données à protocole d'application (16) et/ou que l'opération de rafraîchissement (46) est effectuée lors du démarrage du support de données (10).

5. Procédé selon l'une quelconque des revendications 1 à 4, **caractérisé en ce que** les premières données inscrites dans la mémoire (22) non-volatile en utilisant le mode d'écriture accéléré sont des données qui sont écrasées éventuellement ou probablement pendant l'exploitation ultérieure du support de données (10).

6. Procédé selon l'une quelconque des revendications 1 à 5, **caractérisé en ce que** les premières données inscrites dans la mémoire (22) non-volatile avec l'utilisation du mode d'écriture accéléré comportent des champs d'objet (40) dans un environnement d'exécution de programme orienté objet.

7. Procédé selon l'une quelconque des revendications 1 à 6, **caractérisé en ce que** le support de données (10) est une Java Card et **en ce que** les premières données, qui sont inscrites dans la mémoire (22) non-volatile avec l'utilisation du mode d'écriture accéléré, sont écrites au moins en partie dans une mémoire de stockage (38) d'un environnement de temps de propagation de Java Card.

8. Procédé selon l'une quelconque des revendications 1 à 7, **caractérisé en ce que** le support de données (10) présente un circuit de mesure (74) qui vérifie si un rafraîchissement est indispensable par rapport à l'état de charge actuel d'une unité de la mémoire (22) non-volatile.

9. Procédé selon la revendication 8, **caractérisé en ce que** le contrôle s'effectue en liaison avec l'opération de rafraîchissement (46) et/ou dans un processus d'arrière-plan indépendant de l'opération de rafraîchissement (46) et/ou en cas d'accès de lecture à la mémoire (22) non-volatile et/ou lors du démarrage du support de données (10).

10. Procédé selon la revendication 8 ou la revendication 9, **caractérisé en ce qu'**un rafraîchissement, reconnu comme indispensable lors du contrôle, d'une unité de la mémoire (22) non-volatile est affiché par le placement d'un drapeau (84.x) et/ou le déclenchement d'une interruption.

11. Procédé selon l'une quelconque des revendications 8 à 10, **caractérisé en ce que** les unités rafraîchies de la mémoire (22) non-volatile sont mentionnées et **en ce que** de telles unités sont traitées comme défectueuses lorsqu'à nouveau un rafraîchissement est jugé indispensable lors d'un contrôle suivant.

12. Procédé selon l'une quelconque des revendications 8 à 11, **caractérisé en ce qu'**une unité de la mémoire (22) non-volatile est traitée comme étant défectueuse lorsque, lors du contrôle de cette unité, on constate un état de charge trop différent par rapport à des valeurs de norme (64, 72).

13. Procédé selon l'une quelconque des revendications 8 à 12, **caractérisé en ce que** le rafraîchissement d'une unité de la mémoire (22) non-volatile s'effectue par un circuit de rafraîchissement (86).

14. Produit de programme informatique présentant des instructions de programme qui ordonnent à un processeur (12) d'un support de données (10) portable de mettre en oeuvre un procédé selon l'une quelconque des revendications 1 à 13.

15. Support de données (10) portable, en particulier carte à puce ou module à puce, comprenant un processeur (12) et au moins une mémoire (18, 20, 22), la mémoire (18, 20, 22) contenant des instructions de programme qui ordonnent au processeur (12) la mise en oeuvre d'un procédé selon l'une quelconque des revendications 1 à 13.
